(19) Europäisches Patentamt
European Patent Office
Office européen des brevets

(11) EP 0 762 207 B1

(12) EUROPÄISCHE PATENTSCHRIFT

(45) Veröffentlichungstag und Bekanntmachung des Hinweises auf die Patenterteilung:
**12.04.2000 Patentblatt 2000/15**

(51) Int Cl.$^7$: **G03F 7/004**, G03F 7/039

(21) Anmeldenummer: **96114061.3**

(22) Anmeldetag: **03.09.1996**

# (54) Positivarbeitendes strahlenempfindliches Gemisch und Verfahren zur Herstellung von Reliefstrukturen

Positive working photosensitive composition and method of producing relief structures

Composition photosensible positive et procédé de fabrication de structures en relief

(84) Benannte Vertragsstaaten:
**BE DE FR GB IT NL**

(30) Priorität: **11.09.1995 DE 19533608**

(43) Veröffentlichungstag der Anmeldung:
**12.03.1997 Patentblatt 1997/11**

(73) Patentinhaber: **BASF AKTIENGESELLSCHAFT**
**67056 Ludwigshafen (DE)**

(72) Erfinder:
- **Schwalm, Reinhold, Dr.**
  **67157 Wachenheim (DE)**
- **Funhoff, Dirk, Dr.**
  **69469 Weinheim (DE)**
- **Binder, Horst**
  **68623 Lampertheim (DE)**

(56) Entgegenhaltungen:
**EP-A- 0 412 457**
**EP-A- 0 475 903**
**EP-A- 0 628 876**
**DE-A- 4 306 069**

- **PATENT ABSTRACTS OF JAPAN vol. 016, no. 080 (P-1318), 26.Februar 1992 & JP 03 267941 A (SANYO CHEM IND LTD), 28.November 1991**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 762 207 B1

Printed by Jouve, 75001 PARIS (FR)

## Beschreibung

Die Erfindung betrifft positiv arbeitende strahlungsempfindliche Gemische, die säurelabile Gruppierungen und photoaktive Komponenten enthalten, sensitiv gegenüber aktinischer Strahlung sind und verbesserten Kontrast aufweisen. Diese strahlungsempfindlichen Gemische eignen sich besonders als Resistmaterialien für Einlagenresiste zur Herstellung von Reliefmustern.

Positiv arbeitende strahlungsempfindliche Gemische, die auf dem Prinzip der "chemischen Verstärkung" beruhen, sind an sich bekannt. Dabei wird in einer Primärphotoreaktion eine Spezies erzeugt, die dann unabhängig von der Strahlung eine katalytische Sekundärreaktion auslöst und dadurch die Empfindlichkeit drastisch erhöht. Solche Systeme, die photochemisch eine starke Säure erzeugen, die dann in einer Sekundärreaktion säurelabile Gruppen spaltet, sind z.B. aus US-PS 3 923 514, US-PS 3 915 706 und DE-A 34 06 927 bekannt.

Der Kontrast derartiger Resiste, d.h. die "Schärfe" bei der Differenzierung zwischen unbelichteten und belichteten Bereichen, ist eine wichtige anwendungstechnische Größe. Daher sind Verfahren zur Verbesserung des Kontrasts immer gesucht.

Aufgabe der vorliegenden Erfindung ist es, ein strahlungsempfindliches Gemisch aufzuzeigen, das sehr gute Lichtempfindlichkeit, guten Verarbeitungsspielraum, keinen Schichtdickenverlust zwischen den verschiedenen Prozeßschritten und Reliefstrukturen mit verbessertem Kontrast ergibt.

Diese Aufgabe läßt sich überraschenderweise durch die erfindungsgemäßen positiv arbeitenden strahlungsempfindlichen Gemische lösen.

Gegenstand der vorliegenden Erfindung sind

Positiv arbeitende strahlungsempfindliche Gemische im wesentlichen bestehend aus

($a_1$) mindestens einem säurelabile Gruppierungen enthaltenden, in Wasser unlöslichen, organischen polymeren Bindemittel, das durch Einwirkung von Säure in wäßrig-alkalischen Lösungen löslich wird, oder

(a2.1) einem in Wasser unlöslichen, in wäßrig-alkalischen Lösungen löslichen polymeren Bindemittel und

(a2.2) einer niedermolekularen organischen Verbindung, deren Löslichkeit in einem wäßrig-alkalischen Entwickler durch Einwirkung von Säure erhöht wird, und

(b) mindestens einer organischen Verbindung, welche unter Einwirkung von aktinischer Strahlung eine Säure erzeugt, sowie gegebenenfalls

(c) einer oder mehreren weiteren, von (b) verschiedenen organischen Verbindungen,

die dadurch gekennzeichnet sind, daß mindestens eine der Komponenten (b) und (c) eine Gruppierung der Formeln

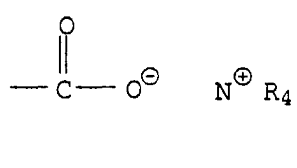 oder 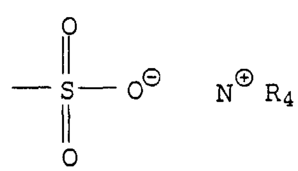

gebunden enthält, oder Komponente (c) der Formel (II) entspricht

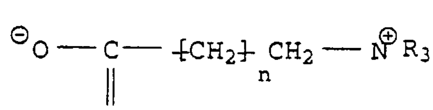

(II)

wobei R jeweils für einen Alkylrest mit 1 bis 6 Kohlenstoffatomen, vorzugsweise $CH_3$ steht und n = 1 bis 6 ist.

Das erfindungsgemäße strahlungsempfindliche Gemisch kann als Komponente (c) eine organische Verbindung aus der Gruppe

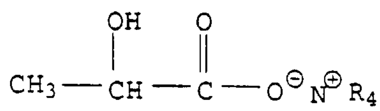

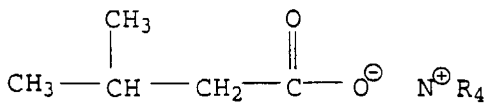

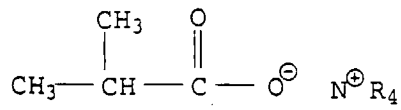

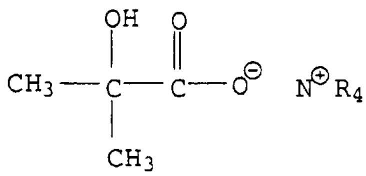

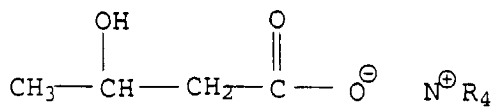

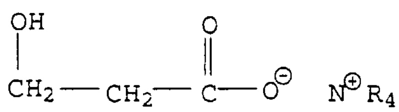

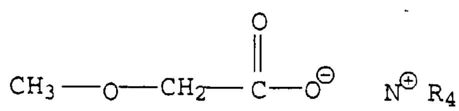

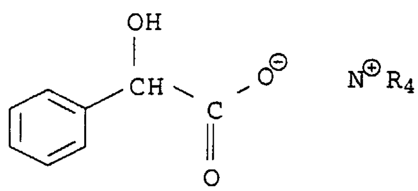

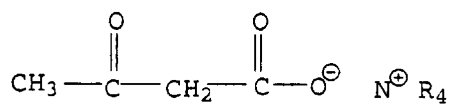

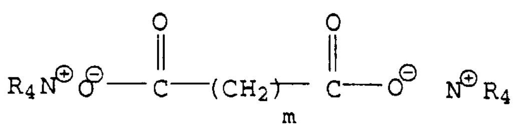 mit m = 1 bis 4,

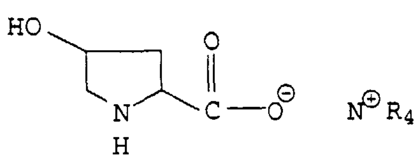 ,

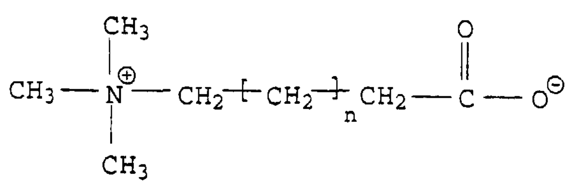

mit n = 1 bis 3

enthalten.

Als Komponente (b) werden vorzugsweise Sulfoniumsalze oder Jodoniumsalze eingesetzt; es können jedoch auch Verbindungen, wie Benzointosylat, Pyrogalloltrimesylat, o-Nitrobenzyltosylat, Diaryldisulfon, Bis-arylsulfonyl-diazomethan, Bis-cyclohexylsulfonyl-diazomethan, Iminosulfonate mit der Struktureinheit

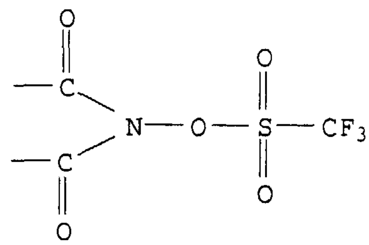

oder Gemische der vorgenannten Verbindungen als Komponente (b) eingesetzt werden.

Bevorzugt sind auch solche strahlungsempfindliche Gemische, deren Polymere ($a_1$) Einheiten der Formeln (VI), (VII) und gegebenenfalls (VIII)

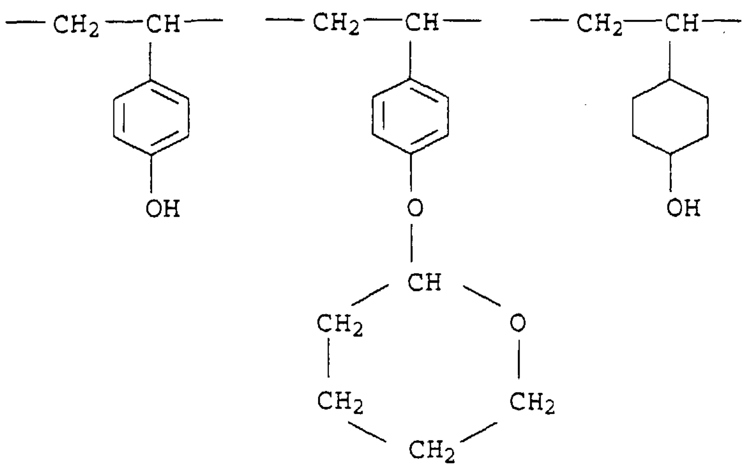

(VI) (VII) (VIII)

eingebaut enthalten, wobei vorzugsweise

35-70 mol% Einheiten der Formel (VI)
30-50 mol% Einheiten der Formel (VII) und
0-15 mol% Einheiten der Formel (VIII)

als Struktureinheiten des Polymeren enthalten sind.

Das erfindungsgemäße strahlungsempfindliche Gemisch liegt vorzugsweise in Form einer Lösung in einem organischen Lösungsmittel oder Lösungsmittelgemisch vor und wird aus dieser verarbeitet.

Gegenstand der vorliegenden Erfindung ist außerdem ein Verfahren zur Herstellung lichtempfindlicher Beschichtungsmaterialien sowie ein Verfahren zur Herstellung von Reliefstrukturen durch Auftragen eines erfindungsgemäßen strahlungsempfindlichen Gemisches in einer Schichtdicke von 0,1 bis 5 µm auf ein in üblicher Weise vorbehandeltes Substrat, Trocknen bei Temperaturen von 70 bis 140°C, bildmäßiges Belichten, gegebenenfalls Erhitzen auf Temperaturen von 40 bis 160°C, und Entwickeln mit einer wäßrig-alkalischen Lösung, wobei das erfindungsgemäße strahlungsempfindliche Gemisch eingesetzt wird.

Die erfindungsgemäßen strahlungsempfindlichen Gemische weisen hohe Empfindlichkeit gegen aktinisches Licht auf und lassen sich zu Reliefstrukturen mit wesentlich verbessertem Kontrast verarbeiten. Außerdem zeichnen sie sich durch leichtere Verarbeitbarkeit, gute Auflösung und bessere Verarbeitungsstabilität aus.

Zu den Aufbaukomponenten des erfindungsgemäßen strahlungsempfindlichen Gemisches ist im einzelnen folgendes auszuführen.

Als säurelabile Gruppierungen enthaltende, in Wasser unlösliche polymere organische Bindemittel ($a_1$), deren Löslichkeit in wäßrig-alkalischen Entwicklern durch Einwirkung von Säure zunimmt, eignen sich beispielsweise Polymere auf Basis von Poly-(p-hydroxistyrol) oder Poly-(p-hydroxi-α-methylstyrol), deren Hydroxylgruppen durch tert.-Butoxy-, tert.-Butoxycarbonyloxy-, tert.-Amylcarbonyloxy oder p-Tetrahydropyranyloxy-gruppen teilweise ersetzt sind, sowie alle üblichen säurelabile Gruppen enthaltenden, in Wasser unlöslichen organischen Bindemittel, deren Löslichkeit in wäßrig-alkalischen Entwicklern durch Einwirkung von Säure zunimmt.

Als verwendbare säurelabile Gruppen sind insbesondere Ether-, Ester-, Acetal-, Ketal- oder Carbonatgruppen zu erwähnen. Bevorzugt dabei sind Ether wie t-Butoxyether, Trimethylsilylether oder t-Butyldimethylsilylether, Acetale wie Tetrahydropyranylether, sowie Ketale wie 4-Methoxy-tetrahydroypyranylether und 1-Methyl-1-methoxyethylether.

Als in Wasser unlösliche säurelabile Gruppierungen enthaltende Polymere ($a_1$), deren Löslichkeit in wäßrig-alkalischen Entwicklern durch Einwirkung von Säure zunimmt, kommen insbesondere Polymere bzw. Copolymere in Frage, die als Monomereinheiten 4-Hydroxystyrol, 2,6-Dimethyl-4-hydroxystyrol, 2-Methyl-4-hydroxystyrol, 4-Hydroxy-alpha-methylstyrol, t-Butoxystyrol, t-Butoxycarbonyloxystyrol, Tetrahydropyranyloxystyrol, t-Butyldimethyl-silyloxystyrol, Trimethylsilyloxystyrol oder 4-Methoxytetrahydropyranyloxystyrol enthalten. Als Comonomeren kommen darüber hinaus alle mit Styrol copolymerisierbaren Monomere, wie z.B. Acrylate, Methacrylate, Schwefeldioxid und Maleinimide, in Betracht.

Die Molekulargewichte ($\overline{M}_w$) dieser Homo- bzw. Copolymere ($a_1$) liegen zwischen 2000 und 100000, bevorzugt zwischen 4000 und 35000. Bevorzugt sind darüber hinaus alle derartigen Polymeren, die in DE-A-4 007 924 und DE-A-4 202 845 beschrieben sind.

Besonders bevorzugt sind auch Polymere ($a_1$), die Einheiten der Formeln (VI), (VII) und (VIII)

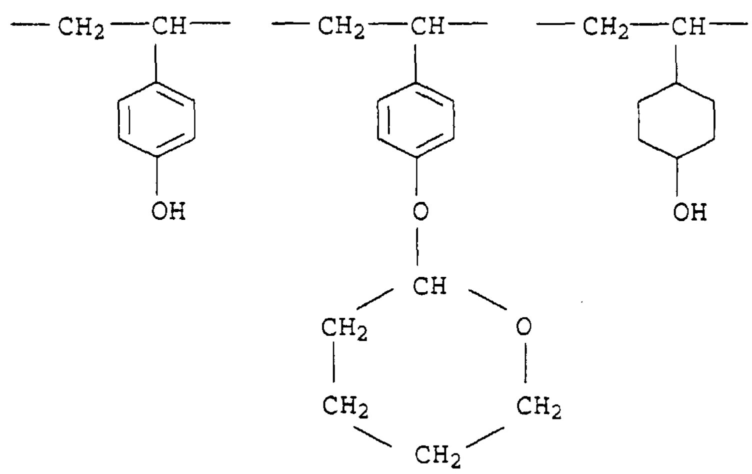

(VI) (VII) (VIII)

eingebaut enthalten.

Derartige erfindungsgemäß einzusetzende Polymere ($a_1$) weisen im allgemeinen Molekulargewichte ($\overline{M}_w$) zwischen 2000 und 100000, vorzugsweise zwischen 4000 und 30000 auf und lassen sich beispielsweise aus Poly-(p-hydroxystyrol) oder vorzugsweise zusätzlich nichtaromatische cyclische Alkoholeinheiten (Vinylcyclohexanol-4-Einheiten) in Mengen bis zu 15 mol% enthaltendem Poly-(p-hydroxystyrol), z.B. durch polymeranaloge Umsetzung mit entsprechenden Mengen Dihydropyran in Gegenwart von Säure herstellen. Ein entsprechendes Verfahren kann der EP-342 498-B (DE-A-3 817 012) entnommen werden.

Als Ausgangsprodukte zur Herstellung derartiger erfindungsgemäß einzusetzender Polymerer ($a_1$) eignen sich beispielsweise auch solche teilweise hydrierten Poly-(p-hydroxystyrole), wie sie der J 01 103 604-A und der EP-A-0 401 499 entnommen werden können.

Derartige Polymere ($a_1$) können die Einheiten der Formeln (VI), (VII) und (VIII) beispielsweise in Mengen von

35-70 mol% Einheiten der Formel (VI),
30-50 mol% Einheiten der Formel (VII) und
0-15 mol% Einheiten der Formel (VIII) eingebaut, enthalten.

Sofern das Polymere ($a_1$) keine Einheiten der Formel (VIII) eingebaut enthält, sind vorzugsweise 50-70 mol% Einheiten der Formel (VI) und 30-50 mol% Einheiten der Formel (VII) als Struktureinheiten eingebaut.

Bevorzugt enthält jedoch das Polymere ($a_1$) Einheiten der Formel (VIII) in Mengen von 2 bis 15 mol%, vorzugsweise 6 bis 14 mol%, bezogen auf die Gesamtmenge der Struktureinheiten der Formeln (VI), (VII) und (VIII), als Struktureinheiten eingebaut. In diesem Fall enthält das Polymer ($a_1$) in aller Regel 37-60 mol%, und insbesondere 38-58 mol% der Struktureinheiten der Formel (VI) und 38 bis 48 mol% der Struktureinheiten der Formel (VII).

Als in Wasser unlösliche, in wäßrig-alkalischen Lösungen lösliche polymere Bindemittel ($a_{2.1}$) kommen Polymere auf Basis von Homo- oder Copolymeren des 4-Hydroxystyrols und/oder 4-Hydroxy-alpha-methylstyrols in Betracht, wobei als Comonomereinheiten besonders in o-Stellung zur Hydroxygruppe mono- oder disubstituierte Hydroxystyrole oder Hydroxystyrole, deren phenolische Gruppe mit säurelabilen Gruppierungen geschützt ist, in Frage kommen. Besonders bevorzugte säurelabile Gruppierungen sind dabei Ether wie t-Butoxyether, Trimethylsilylether oder t-Butyldimethylsilylether, Acetale wie Tetrahydropyranyl-ether, Ester, wie t.-Butylester, sowie Ketale, wie 4-Methoxytetrahydroypyranylether und 1-Methyl-1-methoxyethyl-ether. Diese säurelabile Gruppierungen enthaltenden Comonomereinheiten sind dabei nur in solchen Mengen vorhanden, daß das polymere Bindemittel ($a_{2.1}$) wäßrig alkalisch löslich ist. Im allgemeinen werden dazu Bereiche von 5 - 50 mol-% bevorzugt.

Die Polymeren ($a_{2.1}$) weisen ein Molekulargewicht ($\bar{M}_w$) zwischen 2000 und 100000, vorzugsweise zwischen 4000 und 30000 auf.

Als niedermolekulare organische Verbindungen ($a_{2.2}$), deren Löslichkeit in einem wäßrigen alkalischen Entwickler durch Einwirkung von Säure erhöht wird, welche also säurelabile Gruppen enthalten, seien hier beispielshaft aufgeführt:

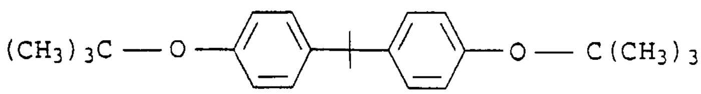

,

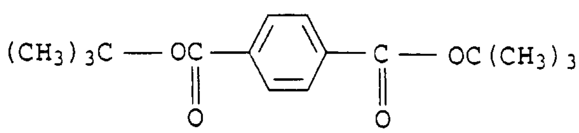

,

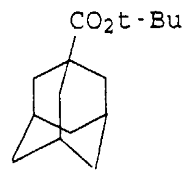

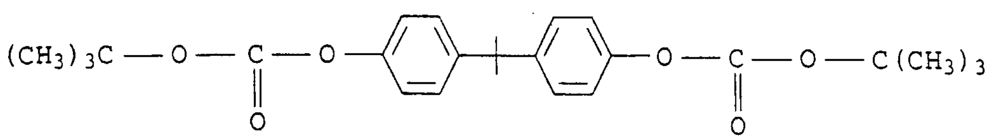

,

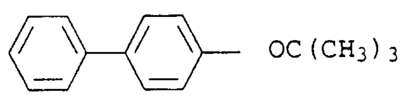

,

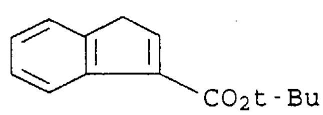

und

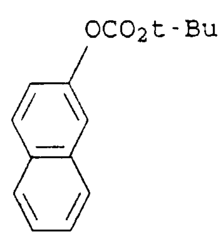

Brauchbar sind auch nichtpolymere Verbindungen, die mindestens ein aromatisches Ringsystem mit einem oder mehreren Tetrahydropyranyloxysubstituenten gemäß der EP-A-0 475 903 aufweisen, beispielsweise:

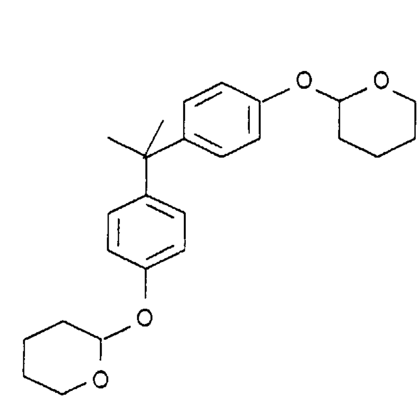

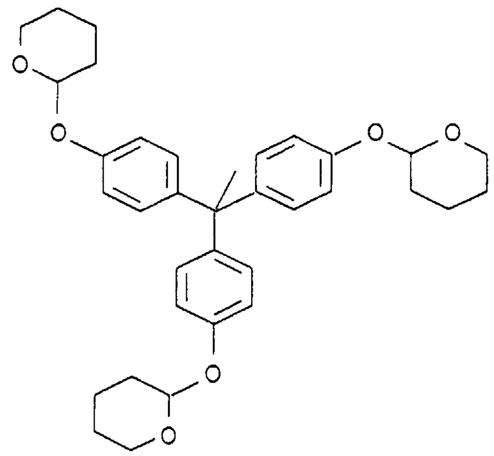

Das Polymere ($a_1$) bzw. die Kombination ($a_{2.1}$) + ($a_{2.2}$) ist im erfindungsgemäßen Gemisch im allgemeinen in einer Menge von 80 bis 99,5, vorzugsweise von 90 bis 99 Gew.-%, bezogen auf die Gesamtmenge der Komponenten ($a_1$) + (b) bzw. ($a_{2.1}$) + ($a_{2.2}$) + (b) enthalten.

Als organische Verbindungen, welche unter Einwirkung von aktinischer Strahlung eine Säure erzeugen (= Säurespender) (b), kommen alle dem Fachmann bekannten photochemischen Säurespender in Frage.

Bevorzugt sind Sulfonium- oder Jodoniumsalze der allgemeinen Formel (IX) oder (X),

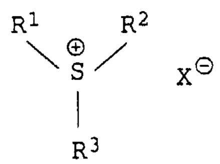

(IX)

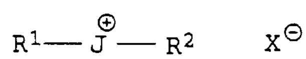

(X)

worin $R^1$, $R^2$ oder $R^3$ untereinander gleich oder verschieden sind und für geradkettig oder verzweigtes Alkyl mit 1 bis 18, vorzugsweise 1 bis 6 Kohlenstoffatomen, wie z.B. Methyl, Ethyl, n-Propyl, Isopropyl, n-Butyl, Isobutyl, tert.-Butyl, Hexyl, Oxaalkyl mit bis zu 3 Sauerstoffatomen und bis zu 10 Kohlenstoffatomen, Aryl mit 6 bis 12 Kohlenstoffatomen, wie z.B. Phenyl oder Naphthyl, $C_1$- bis $C_6$-alkyl- oder $C_1$- bis $C_6$-alkoxysubstituiertes Aryl, Aralkyl, wie z.B. Benzyl, oder den Rest

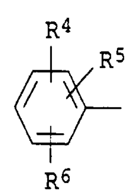

stehen, worin $R^4$, $R^5$ und $R^6$ untereinander gleich oder verschieden sind und für H, OH, Halogen, Alkyl mit 1 bis 18, vorzugsweise 1 bis 6 Kohlenstoffatomen, wie z.B. Methyl, Ethyl, n-Propyl, n-Butyl, Isobutyl, tert.-Butyl, Hexyl, oder Alkoxy mit 1 bis 6 Kohlenstoffatomen, wie z.B. Methoxy, Ethoxy, Propoxy, Butoxy stehen, und $X^{\ominus}$ ein nicht-nukleophiles Gegenion bedeutet.

Beispiele für gut geeignete Komponenten (b) nach den allgemeinen Formeln (IX) bzw. (X) sind Triphenylsulfoniumsalze und Diphenyliodoniumsalze sowie Tris-(4-hydroxyphenyl)sulfoniumsalze und Bis-(4-hydroxyphenyl)iodoniumsalze.

Besonders gut geeignete Sulfoniumsalze besitzen die allgemeine Formel (XI)

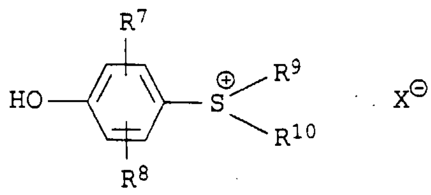

(XI)

worin $R^7$ und $R^8$ untereinander gleich oder verschieden sind und für H, OH, Alkyl mit 1 bis 18, vorzugsweise 1 bis 6 Kohlenstoffatomen, wie z.B. Methyl, Ethyl, n-Propyl, n-Butyl, Isobutyl, tert.-Butyl, Hexyl,oder Alkoxy mit 1 bis 6 Kohlenstoffatomen, wie z.B. Methoxy, Ethoxy, Propoxy, Butoxy, oder Phenyl stehen, $R^9$ und $R^{10}$ untereinander gleich oder verschieden sind und für Alkylreste mit 1 bis 18, vorzugsweise 1 bis 6 Kohlenstoffatomen, wie z.B. Methyl, Butyl stehen oder für Phenyl, Alkyl-, Halogen- oder Hydroxy-substituiertes Phenyl stehen oder $R^9$ mit $R^{10}$ über $CH_2$-Gruppen zu einem fünf- oder sechsgliedrigen Ring geschlossen sind und $X^\ominus$ ein nicht-nukleophiles Gegenion bedeutet.

Beispiele besonders vorteilhafter Sulfoniumsalze sind 4-Hydroxyphenyl-dimethylsulfonium- und 3,5-Dimethyl-4-hydroxyphenyl-dimethylsulfoniumsalze, sowie 3-Ethyl-5-methyl-4-hydroxyphenyldimethylsulfoniumsalze.

Beispiele gut geeigneter, nicht-nukleophiler Anionen $X^\ominus$ sind komplexe Metallhalogenide wie Tetrafluoroborat, Hexafluoroantimonat, Hexafluoroarsenat sowie Hexafluorophosphat und starke organische Säureanionen wie Trifluormethansulfonat (= Triflat) und Fluorsulfonat.

Hervorzuheben sind auch die Sulfoniumsalze der allgemeinen Formel (XII),

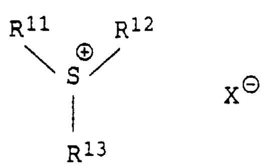

(XII)

worin $R^{11}$, $R^{12}$ und $R^{13}$ untereinander gleich oder verschieden sind und für aliphatische und/oder aromatische Reste, die gegebenenfalls Heteroatome enthalten, stehen oder zwei der Reste $R^{11}$ bis $R^{13}$ miteinander zu einem Ring verknüpft sind, mit der Maßgabe, daß mindestens einer der Reste $R^{11}$ bis $R^{13}$ mindestens eine durch Säure spaltbare Gruppierung, vorzugsweise t-Butylcarbonate von Phenolen bzw. Silylether von Phenolen enthält, wobei einer der Reste $R^{11}$ bis $R^{13}$ mit einem oder mehreren weiteren Sulfoniumsalzresten, gegebenenfalls über durch Säure spaltbare Gruppierungen, verknüpft sein kann, und $X^\ominus$ ein nicht-nukleophiles Gegenion bedeutet.

Es können auch zwei oder mehrere Sulfoniumeinheiten im Molekül über die Reste $R^{11}$ bis $R^{12}$ verknüpft sein.

Bevorzugte Sulfoniumsalze der allgemeinen Formel (XII) sind solche, in denen $R^{11}$ und $R^{12}$ für Methylgruppen und $R^{13}$ für substituierte Phenylderivate mit säurespaltbaren Gruppen stehen, z.B.

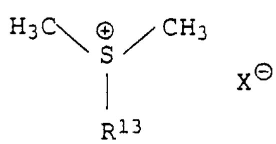

worin $R^{13}$ z.B. für 4-t-Butoxycarbonyloxyphenyl-, 4-t-Butoxycarbonyloxy-3,5-dimethylphenyl, 4-t-Butoxycarbonyloxy-3-methylphenyl-, 4-t-Butoxycarbonyloxy-2-methyl-phenyl-, 4-t-Butoxycarbonyloxy-3,5-dimethoxyphenyl, 4-t-Butoxicarbonyloxy-3,5-dimethylphenyl-, 1-t-Butoxycarbonyloxy-naphthyl-, 4-Trimethylsilyl-oxy-phenyl, 4-Trimethylsilyl-oxy-napththyl- stehen oder auch solche, in denen zwei der Reste $R^{11}$ bis $R^{13}$ miteinander zu einem Ring, insbesondere einem fünf- oder sechsgliedrigen Ring verknüpft sind, wobei z.B. $R^{11}$ und $R^{12}$ beispielsweise zu Tetramethylengruppen verbrückt sind und $R^{13}$ die gleiche Bedeutung wie vorstehend hat:

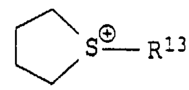

oder Verbindungen, in denen $R^{11}$ für Methyl und $R^{12}$ für Phenyl bzw. Tolyl stehen und $R^{13}$ für ein substituiertes Phenylderivat mit säurespaltbaren Gruppen steht, worin $R^{13}$, für 4-t-Butoxycarbonyloxy-phenyl-, 2,4-Di-t-butoxycarbonyloxy-phenyl-, 4-t-Butoxycarbonyloxy-2-methoxy-phenyl, 4-Trimethylsilylphenyl- steht, oder worin $R^{11}$ für Phenyl oder $C_1$- bis $C_{12}$-alkyl-substituiertes Phenyl oder halogensubstituiertes Phenyl steht und $R^{12}$ und $R^{13}$ substituierte Phenylderivate mit säurespaltbaren Gruppen sind, worin $R^{12}$ und $R^{13}$ z.B. 4-t-Butoxycarbonyloxy-phenyl, 4-Trimethylsilyloxyphenyl, 4-t-Butyl-dimethylsilyloxyphenyl-, 4-t-Butoxycarbonyloxy-3,5-dimethylphenyl- oder $R^{11}$, $R^{12}$ und $R^{13}$ untereinander gleich sind, d.h. Sulfoniumsalze, in denen diese Reste mit säurespaltbaren Gruppen dreimal enthalten sind.

Bevorzugte Beispiele für Verbindungen (b) sind Dimethyl-4-t-butoxycarbonyloxy-phenyl-sulfoniumsalze mit Hexafluoroarsenat, Hexafluoroantimonat, Hexafluorophosphat, Hexafluoroborat oder Trifluormethansulfonat als Gegenion, Phenyl-(bis-(4-t-butoxycarbonyloxyphenyl-)sulfoniumsalz mit den genannten Gegenionen, Tris-(4-t-butoxycarbonyloxyphenyl-)sulfoniumsalz mit den genannten Gegenionen oder 1-Naphthyl-4-trimethylsilyloxytetramethylensulfoniumsalze mit den genannten Gegenionen.

Außer diesen Sulfonium- und Jodoniumsalzen eignen sich als organische Verbindungen (b), welche unter Einwirkung von aktinischer Strahlung eine Säure erzeugen, beispielsweise Benzointosylat, Pyrogallotrimesylat, o-Nitrobenzyltosylat, Diaryldisulfone, wie z.B. Diphenyldisulfon oder substituierte Diphenyldisulfone der Formel

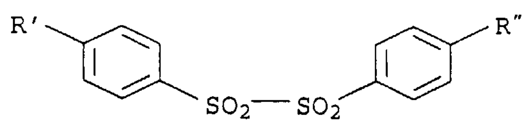

worin R' und R" untereinander gleich oder verschieden sind und für H, $CH_3$, $C_2H_5$, $C_3H_7$, $C_4H_9$, $OCH_3$, $OC_2H_5$ oder Cl stehen, wie z.B. Di-(p-tolyl)disulfon, Bis-arylsulfonyl-diazomethane, z.B. solche der Formel

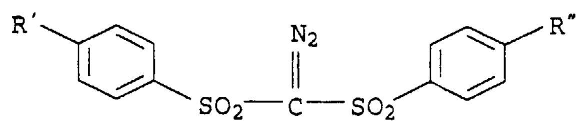

worin R' und R" untereinander gleich oder verschieden sind und für H, $CH_3$, $C_2H_5$, $C_3H_7$, $C_4H_9$,

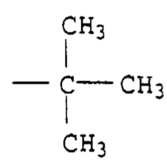

oder Cl stehen,
Bis-cyclohexyl-sulfonyl-diazomethan, Iminosulfonate mit der Struktureinheit

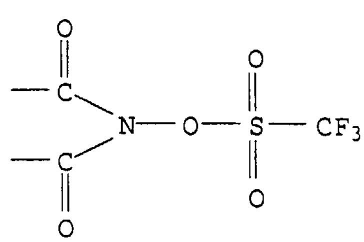 ,

wie z.B.

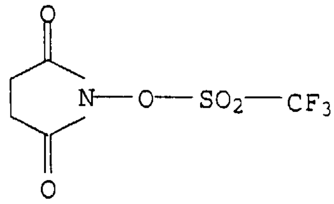

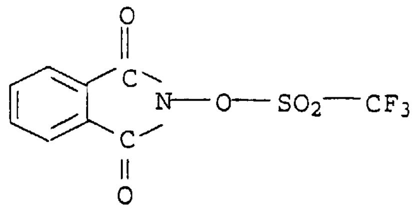

und/oder

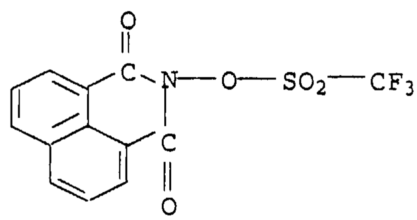

Ebenfalls bevorzugt werden als Komponente (b) Alkylsulfonsäureester von Verbindungen, die mindestens zwei phenolische Hydroxy-Gruppen enthalten. Beispiele besonders gut geeigneter Substanzen sind 1,2,3-Tris-(methansulfonyloxy)benzol und 1,3-Bis-(methansulfonyloxy)benzol oder Disulfone wie z.B. Diphenyldisulfon, 4-Methoxyphenyl-phenyldisulfon oder Bis-(4-hydroxyphenyl)disulfon.

Auch Gemische der unter (b) genannten Verbindungen mit sich selbst oder anderen, hier nicht explizit aufgeführten organischen photochemischen Säurespendern können eingesetzt werden. Die Menge der Summe aller Komponenten (b) beträgt im erfindungsgemäßen strahlungsempfindlichen Gemisch im allgemeinen 0,5 bis 20, vorzugsweise 1 bis 10 Gew.-%, bezogen auf die Summe aller Komponenten ($a_1$) + (b) bzw. ($a_{2.1}$) + ($a_{2.2}$) + (b) im strahlungsempfindlichen Gemisch.

Als erfindungsgemäß gegebenenfalls einzusetzende Komponente (c) kommen folgende organische Verbindungen in Betracht, die Gruppierungen der Formel (Ia) oder (II)

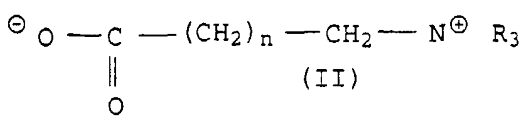
(II)

mit n = 1 bis 6,

Ia 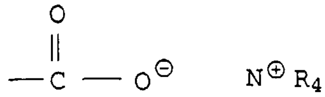

enthalten, beispielsweise:

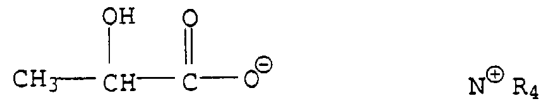

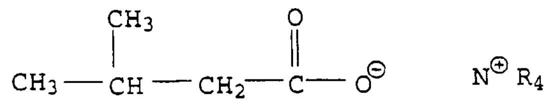

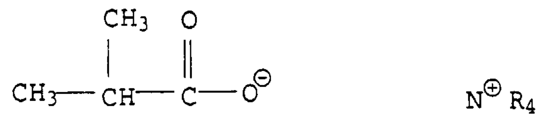

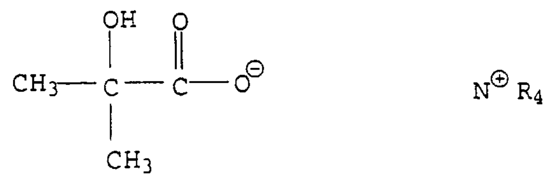

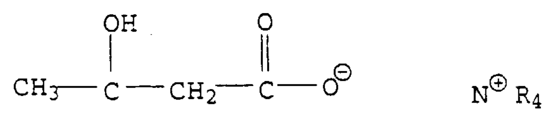

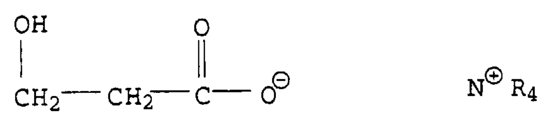

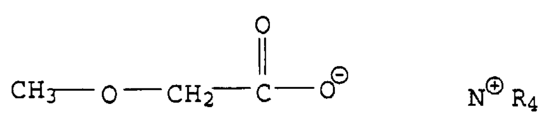

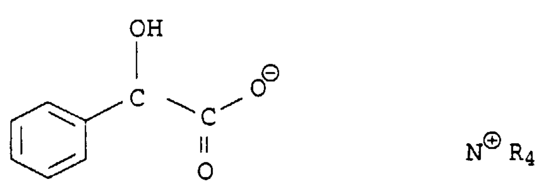

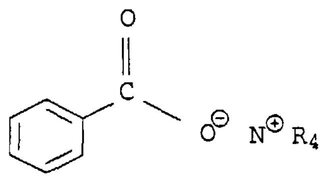

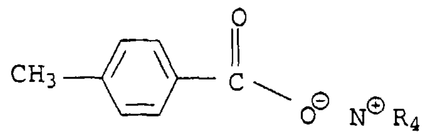

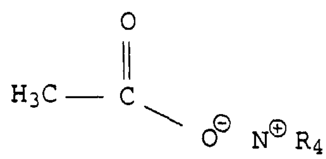

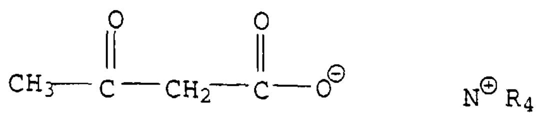

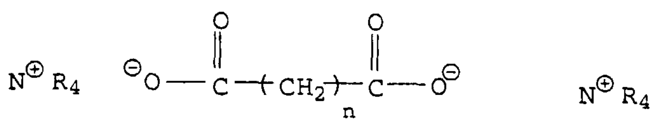

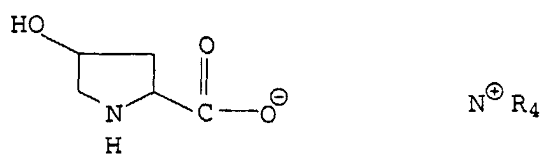

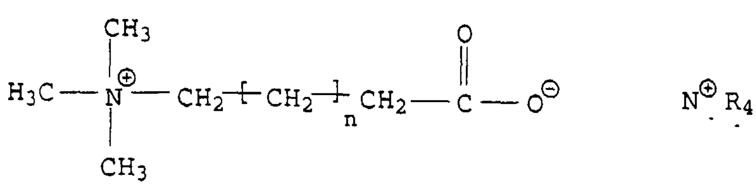

mit n = 1, 2 oder 3.

Die Tetraalkylammoniumgruppe ist im erfindungsgemäßen strahlungsempfindlichen Gemisch im allgemeinen in Mengen von 0,01 bis 50, vorzugsweise 0,1 bis 10 Molprozent, bezogen auf die Komponente (b) enthalten.

Das erfindungsgemäße strahlungsempfindliche Gemisch kann zusätzlich noch weitere, dem Stand der Technik entsprechende, übliche Hilfs- und Zusatzstoffe (Sensibilisatoren, Farbstoffe, Verlaufshilfsmittel, Netzhilfsmittel, Stabilisatoren usw.) enthalten. Diese Zusatzstoffe werden im allgemeinen in Mengen von weniger als 3 Gew.-% zugesetzt.

Die erfindungsgemäßen Gemische werden zur Herstellung von Resists bevorzugt in einem organischen Lösungsmittel gelöst, wobei der Feststoffgehalt üblicherweise im Bereich zwischen 5 und 40 Gew.-% liegt. Als Lösungsmittel kommen bevorzugt aliphatische Ketone, Ether und Ester, sowie Mischungen derselben in Frage. Besonders bevorzugt sind Alkylenglykol-monoalkylether, wie beispielsweise Ethylcellosolve, Butylglykol, Methylcellosolve und 1-Methoxy-2-propanol, Alkylenglykolalkylether-ester, wie beispielsweise Methylcellosolveacetat, Methylpropylenglykolacetat und Ethylpropylenglykolacetat, Ketone, wie beispielsweise Cyclohexanon, Cyclopentanon und Methylethylketon, sowie Acetate wie Butylacetat, Ethylacetat, andere Ester, wie Ethyllactat und Butyrolacton sowie Aromaten wie Toluol und Xylol. Die Auswahl der entsprechenden Lösungsmittel, sowie deren Mischungen richtet sich nach der Wahl der jeweiligen Komponenten des strahlungsempfindlichen Gemischs.

Weiterhin können andere Zusätze wie Haftvermittler und Weichmacher zugesetzt werden, im allgemeinen in Mengen von bis zu 1 Gew.-%.

Die erfindungsgemäßen strahlungsempfindlichen Gemische sind sensitiv gegenüber Röntgen-, Elektronen- und UV-Strahlung. Gegebenenfalls können Sensibilisatoren in geringen Mengen zugesetzt werden, wie beispielsweise Pyren und Perylen, um die Verbindungen im längerwelligen UV bis hin zum sichtbaren Wellenlängenbereich zu sensibilisieren. Für die Belichtung in speziellen Wellenlängenbereichen, wie beispielsweise im kurzwelligen UV (< 300 nm), ist eine hohe Transparenz der Schichten bei der jeweiligen Belichtungswellenlänge gefordert. In gängigen Belichtungsgeräten auf Basis von Quecksilberlampen nutzt man die 254 nm Linie oder man verwendet Excimer-Laser, die bei 248 nm (KrF) emittieren.

Strahlungsempfindliche Aufzeichnungsmaterialien sollten deshalb in diesem Bereich möglichst niedrige optische Dichten aufweisen.

Bei dem erfindungsgemäßen Verfahren zur Herstellung von positiven Reliefmustern wird eine strahlungsempfindliche Aufzeichnungsschicht, die im wesentlichen aus dem erfindungsgemäßen strahlungsempfindlichen Gemisch besteht, bildmäßig mit aktinimischem Licht in solcher Dosis bestrahlt, daß die Löslichkeit der belichteten Bereiche nach einem thermischen Ausheizschritt bei Temperaturen zwischen 40 und 160°C in wäßrig-alkalischen Lösungsmitteln zunimmt und diese Bereiche selektiv mit dem alkalischen Entwickler entfernt werden können.

Die das erfindungsgemäße strahlungsempfindliche Gemisch enthaltenden Photoresistlösungen werden im allgemeinen in Schichtdicken von 0,1 bis 5 µm, vorzugsweise 0,5 bis 1,5 µm auf geeignete Substrate, beispielsweise oberflächlich oxidierte Silizium-Wafer durch Aufschleudern (spin coating) aufgetragen, getrocknet (z.B. bei Temperaturen zwischen 70 und 140°C) und mit einer geeigneten Lichtquelle durch eine Photomaske bildmäßig belichtet, z.B. mit kurzwelligen UV-Strahlen (deep UV) mit Wellenlängen zwischen 200 und 300 nm. Besonders geeignete Lichtquellen sind Excimer-Laser von KrF (248 nm). Nach dem bildmäßigen Belichten wird - gegebenenfalls nach kurzem Ausheizen (postbake) bei Temperaturen bis zu 160°C - mit üblichen wäßrig-alkalischen Entwicklerlösungen - im allgemeinen bei pH-Werten zwischen 12 und 14 - entwickelt, wobei die belichteten Stellen ausgewaschen werden. Die Auflösung liegt im Submikron-Bereich. Die für die erfindungsgemäßen strahlungsempfindlichen Gemische benötigte Belichtungsenergie liegt im allgemeinen zwischen 10 und 300 $mJ/cm^2$ bei Schichtdicken von 1 µm.

Die erfindungsgemäßen strahlungsempfindlichen Gemische zeichnen sich durch hohe Empfindlichkeit, gute Auflösung und leichte Verarbeitbarkeit, insbesondere verbesserten Belichtungsspielraum sowie gute Lagerstabilität nach der Belichtung aus und eignen sich daher besonders vorteilhaft für die Lithographie im kurzwelligen Bereich, da sowohl Kontrast als auch Focustiefe verbessert sind.

Der Kontrast des Resists, ausgedrückt mittels des Gamma-Werts ($\Gamma_p$), wurde aus einer Auftragung von Schichtdicke gegen Belichtungsdosis ermittelt. Für Positiv-Resistsysteme ist der Gamma-Wert definiert als

$$\Gamma_p = [\log \frac{D_1}{D_0}]^{-1}$$

wobei $D_0$ und $D_1$ die extrapolierten Belichtungsenergiedosen aus der Dunkelabtragsenergiekurve darstellen.

Die in den Beispielen und Vergleichsbeispielen genannten Teile und Prozente sind, soweit nicht anders angegeben, Gewichtsteile bzw. Gewichtsprozente.

Vergleichsbeispiel 1

Eine Photoresistlösung wurde aus 5 Teilen 4-Hydroxyphenyl-dimethylsulfoniumtriflat, 95 Teilen Poly-[4-hydroxystyrol-co-4-tetrahydropyranyloxystyrol]
(Molares Verhältnis der Comonomeren 60:40)
und 300 Teilen Ethyllaktat hergestellt.

Diese Lösung wurde durch ein Filter mit einem Porendurchmesser von 0,2 µm filtriert.

Von dieser Lösung wurde eine ca. 0,8 µm dicke Schicht auf oberflächlich oxidierte Siliziumwafer aufgeschleudert und 1 Min. bei 130°C ausgeheizt. Nach der Belichtung durch eine strukturierte Testmaske mit Excimer-Laserlicht der Wellenlänge 248 nm wurde dieser Wafer bei 130°C für 1 Min. ausgeheizt und mit einem wäßrig-alkalischen Entwickler 1 Min. entwickelt.

Nach Messung der auf dem Testwafer zurückgebliebenen Photolackschichten wurde der Kontrast des Resistes ermittelt. Es ergab sich ein Gamma-Wert von 6.

Beispiel 1

Eine Photoresistlösung wurde analog Vergleichsbeispiel 1 hergestellt, jedoch wurden 3 Mol% Trimethylammoniumbutyrobetain, bezogen auf 4-Hydroxyphenyl-dimethylsulfoniumtriflat, zugegeben. Nach der in Vergleichsbeispiel 1 beschriebenen Weiterverarbeitung ergab sich ein Gamma-Wert von 7.

Beispiel 2

Eine Photoresistlösung, die analog Vergleichsbeispiel 1, jedoch mit einem Zusatz von 5 Mol% Trimethylammoniumbutyrobetain, bezogen auf 4-Hydroxyphenyl-dimethylsulfoniumtriflat, hergestellt wurde, ergab einen Gamma-Wert von 9.

Beispiel 3

Die Resistlösungen von Vergleichsbeispiel 1 und den Beispielen 1 und 2 wurden zur Überprüfung der photolithografischen Eigenschaften auf Wafer von 200 mm Durchmesser in einer Schichtdicke von ca. 800 nm aufgetragen. Nach dem Ausheizen bei 130°C auf einer Hotplate wurden die Wafer mit einem Waferstepper der Firma ASM Lithography, Typ PAS 5500 belichtet. Nach unterschiedlichen Wartezeiten wurden die Wafer anschließend bei 130°C getempert und in einem wäßrig-alkalischen Entwickler ausgewaschen.

Anschließend wurden die Linienbreiten in Abhängigkeit von der Wartezeit rasterelektronenmikroskopisch ermittelt.

Nachfolgende Tabelle zeigt die gefundenen Linienbreiten von 250 nm-Strukturen.

| | | Wartezeit | | |
|---|---|---|---|---|
| | | 10 min | 30 min | 60 min |
| Vergleichsbeispiel 1 | ohne Zusatz | 254 nm | 230 nm | 220 nm |
| Beispiel 1 | mit 2 mol % Triethylammoniumbutyrobetain | 255 nm | 250 nm | 245 nm |
| Beispiel 2 | mit 5 mol % Trimethylammoniumbutyrobetain | 253 nm | 250 nm | 246 nm |

Vergleichsbeispiel 2

Eine Photoresistlösung wurde aus 5 Teilen 2,3,5-Trimethyl-4-hydroxyphenyl-dimethylsulfoniumtriflat, 95 Teilen Poly-[4-hydroxystyrol-co-4-tetrahydropyranyloxystyrol]
(Molares Verhältnis der Comonomeren 55:45)
und 300 Teilen Ethyllaktat hergestellt und anschließend durch ein Filter mit einem Porendurchmesser von 0,2 µm filtriert.

Von dieser Lösung wurde eine ca. 0,8 µm dicke Schicht auf oberflächlich oxidierte Siliziumwafer aufgeschleudert und 1 Min. bei 130°C ausgeheizt. Nach der Belichtung durch eine strukturierte Testmaske mit Excimer-Laserlicht der Wellenlänge 248 nm wurde dieser Wafer bei 130°C für 1 Min. ausgeheizt und mit einem wäßrig-alkalischen Entwickler 1 Min. entwickelt.

Nach Messung der auf dem Testwafer zurückgebliebenen Photolackschichten wurde der Kontrast des Resistes ermittelt. Es ergab sich ein Gamma-Wert von 7.

Beispiel 4

Eine Photoresistlösung wurde analog Vergleichsbeispiel 2 hergestellt, jedoch wurden 3 Mol% der Verbindung

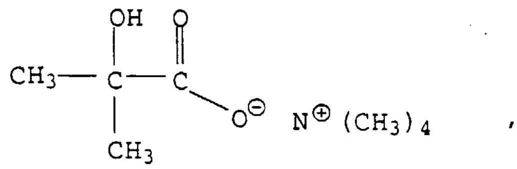

(=C1) bezogen auf 2,3,5-Trimethyl-4-hydroxyphenyl-dimethylsulfoniumtriflat zugegeben.

Nach der Verarbeitung gemäß Vergleichsbeispiel 2 ergab sich ein Gamma-Wert von 10.

Beispiel 5

Eine Photoresistlösung wurde analog Beispiel 2, jedoch mit 6 mol% der Verbindung C1, bezogen auf 2,3,5-Trimethyl-4-hydroxyphenyldimethylsulfoniumtriflat hergestellt. Es ergab sich ein Gamma-Wert von 9,5.

Beispiel 6

Die Resistlösungen von Vergleichsbeispiel 2 und den Beispielen 4 und 5 wurden zur Überprüfung der Lagerstabilität auf 200 mm-Wafer in einer Schichtdicke von ca. 800 nm aufgetragen.

Die weitere Verarbeitung und Prüfung erfolgte wie unter Beispiel 3 beschrieben.

| | | Wartezeit | | |
|---|---|---|---|---|
| | | 10 min | 30 min | 60 min |
| Vergleichsbeispiel 2 | ohne Zusatz von C1 | 252 nm | 235 nm | 225 nm |
| Beispiel 4 | mit 3 mol % C1 | 252 nm | 250 nm | 243 nm |
| Beispiel 5 | mit 6 mol % C1 | 251 nm | 250 nm | 248 nm |

Vergleichsbeispiel 3

Eine Photoresistlösung wurde aus 5 Teilen 2-Methyl-4-hydroxi-5-isopropyl-phenyl-dimethylsulfoniumtriflat, 95 Teilen Poly-[4-hydroxystyrol-co-4-tetrahydropyranyloxystyrol]
(Molares Verhältnis der Comonomeren 65:35)
und 320 Teilen Ethyllaktat hergestellt und anschließend durch ein Filter mit einem Porendurchmesser von 0,2 µm filtriert.

Von dieser Lösung wurde eine ca. 0,8 µm dicke Schicht auf oberflächlich oxidierte Siliziumwafer aufgeschleudert und 1 Min. bei 130°C ausgeheizt. Nach der Belichtung durch eine strukturierte Testmaske mit Excimer-Laserlicht der Wellenlänge 248 nm wurde dieser Wafer bei 130°C für 1 min. ausgeheizt und mit einem wäßrig-alkalischen Entwickler 1 min. entwickelt.

Nach Messung der auf dem Testwafer zurückgebliebenen Photolackschichten wurde der Kontrast des Resistes ermittelt. Es ergab sich ein Gamma-Wert von 6.

Beispiel 7

Eine Photoresistlösung wurde analog Vergleichsbeispiel 3 hergestellt, jedoch wurden 3 Mol% der Verbindung

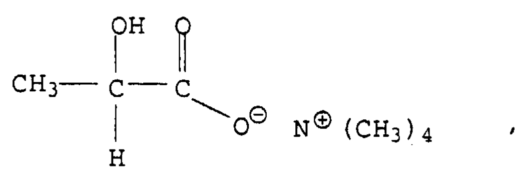

(=C2) bezogen auf 2-Methyl-4-hydroxy-5-isopropylphenyl-dimethylsulfoniumtriflat zugegeben.

Nach der Verarbeitung gemäß Vergleichsbeispiel 3 ergab sich ein Gamma-Wert von 8.

Beispiel 8

Eine Photoresistlösung wurde analog Vergleichsbeispiel 3, jedoch mit 5 mol% der Verbindung C2, bezogen auf 2-Methyl-4-hydroxy-5-isopropyl-phenyl-dimethylsulfoniumtriflat hergestellt. Es ergab sich ein Gamma-Wert von 8.

Beispiel 9

Die Resistlösungen von Vergleichsbeispiel 3 und den Beispielen 7 und 8 wurden zur Überprüfung der Lagerstabilität auf 200 mm-Wafer in einer Schichtdicke von ca. 800 nm aufgetragen.
Die weitere Verarbeitung erfolgte wie unter Beispiel 3 beschrieben.

| | | Wartezeit | | |
|---|---|---|---|---|
| | | 10 min | 30 min | 60 min |
| Vergleichsbeispiel 3 | ohne Zusatz von C2 | 249 nm | 230 nm | 220 nm |
| Beispiel 7 | mit 3 mol % C2 | 251 nm | 250 nm | 245 nm |
| Beispiel 8 | mit 5 mol % C2 | 252 nm | 252 nm | 249 nm |

Beispiel 10

In einem weiteren Experiment wurde der Belichtungsspielraum ermittelt. Die sog. "Depth of Focus" wurde bestimmt, indem die Wafer mit unterschiedlichen Belichtungsdosen und veränderlicher Focustiefe des Belichtungsgerätes prozessiert wurden. Nach der Entwicklung mit einem wäßrig-alkalischen Entwickler wurden die Breiten der hergestellten Linien mit einem Rasterelektronenmikroskop bestimmt.
Da die Depth of Focus von den Maskendimensionen abhängig ist, wurden unterschiedliche Linienbreiten ausgemessen.
Für die Resistformulierungen aus Vergleichsbeispiel 3 und den Beispielen 7 und 8 wurden folgende Resultate erhalten:

| | Depth of Focus (µm) bei einer Linienbreite von | |
|---|---|---|
| | 250 nm | 350 nm |
| Vergleichsbeispiel 3 | 0,8 | 1,2 |
| Beispiel 7 | 1,3 | 1,6 |
| Beispiel 8 | 1,3 | 1,6 |

Vergleichsbeispiel 4

Eine Photoresistlösung wurde aus 5 Teilen 2-Methyl-4-hydroxy-5-isopropyl-phenyl-dimethylsulfoniumtriflat, 95 Teilen Poly-[4-hydroxystyrol-co-4-tetrahydropyranyloxystyrol-co-4-vinyl-cyclohexanol]
(Molares Verhältnis der Comonomeren 55:38:7)
und 320 Teilen Ethyllaktat hergestellt und anschließend durch ein Filter mit einem Porendurchmesser von 0,2 µm filtriert.
Von dieser Lösung wurde eine ca. 1,0 µm dicke Schicht auf oberflächlich oxidierte Siliziumwafer aufgeschleudert und 1 Min. bei 130°C ausgeheizt. Nach der Belichtung durch eine strukturierte Testmaske mit Excimer-Laserlicht der Wellenlänge 248 nm wurde dieser Wafer bei 130°C für 1 min. ausgeheizt und mit einem wäßrig-alkalischen Entwickler 1 min. entwickelt.
Nach Messung der auf dem Testwafer zurückgebliebenen Photolackschichten wurde der Kontrast des Resistes ermittelt. Es ergab sich ein Gamma-Wert von 6,5.

Beispiel 11

Eine Photoresistlösung wurde analog Vergleichsbeispiel 4 hergestellt, jedoch wurden 5 Mol% der Verbindung

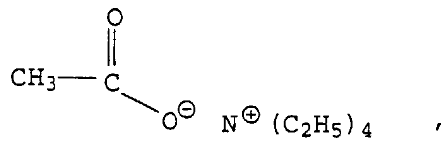

Tetraethylammoniumacetat (=C4) bezogen auf 2-Methyl-4-hydroxy-5-isopropyl-phenyl-dimethylsulfoniumtriflat zugegeben.

Nach der Verarbeitung gemäß Vergleichsbeispiel 4 ergab sich ein Gamma-Wert von 9.

Beispiel 12

Die Resistlösungen aus Vergleichsbeispiel 4 und Beispiel 11 wurden zur Überprüfung der Depth of Focus auf 200 mm-Wafer in einer Schichtdicke von ca. 100 nm aufgetragen.

Die weitere Verarbeitung erfolgte wie unter Beispiel 10 beschrieben.

Für die Resistformulierungen von Vergleichsbeispiel 4 und Beispiel 11 ergaben sich folgende Resultate:

| | Depth of Focus (µm) bei einer Linienbreite von | |
|---|---|---|
| | 250 nm | 350 nm |
| Vergleichsbeispiel 4 | 0,7 nm | 1,1 nm |
| Beispiel 11 | 1,2 nm | 1,7 nm |

Vergleichsbeispiel 5

Eine Photoresistlösung wurde aus 2,5 Teilen 2-Methyl-4-hydroxy-5-isopropyl-phenyl-dimethylsulfoniumtriflat, 2,5 Teilen 3,5-Dimethyl-4-hydroxyphenyl-dimethylsulfoniumtriflat, 95 Teilen Poly-[4-hydroxystyrol-co-4-tetrahydropyranyloxystyrol-co-4-vinylcyclohexanol]
(Molares Verhältnis der Comonomeren 48:40:12)
und 320 Teilen Ethyllaktat hergestellt und anschließend durch ein Filter mit einem Porendurchmesser von 0,2 µm filtriert.

Von dieser Lösung wurde eine ca. 0,8 µm dicke Schicht auf oberflächlich oxidierte Siliziumwafer aufgeschleudert und 1 min. bei 130°C ausgeheizt. Nach der Belichtung durch eine strukturierte Testmaske mit Excimer-Laserlicht der Wellenlänge 248 nm wurde dieser Wafer bei 130°C für 1 min. ausgeheizt und mit einem wäßrig-alkalischen Entwickler 1 min. entwickelt.

Nach Messung der auf dem Testwafer zurückgebliebenen Photolackschichten wurde der Kontrast des Resistes ermittelt. Es ergab sich ein Gamma-Wert von 7,5.

Beispiel 13

Eine Photoresistlösung wurde analog Vergleichsbeispiel 5 hergestellt, jedoch wurden 6 Mol% Tetraethylammonium-(toluol-4-sulfonat) (= C5) bezogen auf 2-Methyl-4-hydroxy-5-isopropyl-phenyl-dimethylsulfoniumtriflat zugegeben.

Nach der Verarbeitung gemäß Vergleichsbeispiel 5 ergab sich ein Gamma-Wert von 8,5.

Beispiel 14

Eine Photoresistlösung wurde analog Vergleichsbeispiel 5 hergestellt, jedoch wurden 10 Mol% Tetraethylammonium-(toluol-4-sulfonat) (= C5), bezogen auf 2-Methyl-4-hydroxy-5-isopropyl-phenyl-dimethylsulfoniumtriflat zugegeben.

Nach der Verarbeitung gemäß Vergleichsbeispiel 5 ergab sich ein Gamma-Wert von ebenfalls 8,5.

Vergleichsbeispiel 6

Eine Photoresistlösung wurde aus 3 Teilen 4-Methoxyphenylphenyldisulfon, 95 Teilen Poly-[4-hydroxystyrol-co-4-tetrahydropyranyloxystyrol-co-4-vinyl-cyclohexanol]

(Molares Verhältnis der Comonomeren 49:38:13)
und 320 Teilen Ethyllaktat hergestellt und anschließend durch ein Filter mit einem Porendurchmesser von 0,2 µm filtriert.

Von dieser Lösung wurde eine ca. 0,8 µm dicke Schicht auf oberflächlich oxidierte Siliziumwafer aufgeschleudert und 1 min. bei 130°C ausgeheizt. Nach der Belichtung durch eine strukturierte Testmaske mit Excimer-Laserlicht der Wellenlänge 248 nm wurde dieser Wafer bei 130°C für 1 min. ausgeheizt und mit einem wäßrig-alkalischen Entwickler 1 min. entwickelt.

Nach Messung der auf dem Testwafer zurückgebliebenen Photolackschichten wurde der Kontrast des Resistes ermittelt. Es ergab sich ein Gamma-Wert von 5,5.

Beispiel 15

Eine Photoresistlösung wurde analog Vergleichsbeispiel 6 hergestellt, jedoch wurden 5 mol% der Verbindung

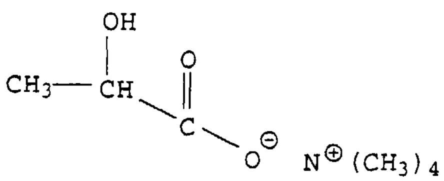

(=C6), bezogen auf 4-Methoxyphenyl-phenyldisulfon, zugegeben.

Nach der Verarbeitung gemäß Vergleichsbeispiel 6 ergab sich ein Gamma-Wert von 7,5.

Beispiel 16

Die Resistlösungen aus Vergleichsbeispiel 6 und Beispiel 15 wurden zur Überprüfung der Depth of Focus auf 200 mm-Wafer in einer Schichtdicke von ca. 800 nm aufgetragen.

Die weitere Verarbeitung erfolgte wie unter Beispiel 10 beschrieben.

Für die Resistformulierungen aus Vergleichsbeispiel 6 und Beispiel 15 ergaben sich folgende Resultate:

| | Depth of Focus (µm) bei einer Linienbreite von | |
|---|---|---|
| | 250 nm | 350 nm |
| Vergleichsbeispiel 6 | 0,6 | 1,0 |
| Beispiel 15 | 1,0 | 1,3 |

Vergleichsbeispiel 7

Eine Photoresistlösung wurde aus 6 Teilen Bis-4-Methylphenylsulfonyl-diazomethan, 95 Teilen Poly-[4-hydroxystyrol-co-4-tetrahydropyranyloxystyrol-co-4-vinyl-cyclohexanol]
(Molares Verhältnis der Comonomeren 49:38:13)
und 320 Teilen Ethyllaktat hergestellt und anschließend durch ein Filter mit einem Porendurchmesser von 0,2 µm filtriert.

Von dieser Lösung wurde eine ca. 0,8 µm dicke Schicht auf oberflächlich oxidierte Siliziumwafer aufgeschleudert und 1 min. bei 100°C ausgeheizt. Nach der Belichtung durch eine strukturierte Testmaske mit Excimer-Laserlicht der Wellenlänge 248 nm wurde dieser Wafer bei 100°C für 1 min. ausgeheizt und mit einem wäßrig-alkalischen Entwickler 1 min. entwickelt.

Nach Messung der auf dem Testwafer zurückgebliebenen Photolackschichten wurde der Kontrast des Resistes ermittelt. Es ergab sich ein Gamma-Wert von 6,4.

Beispiel 17

Eine Photoresistlösung wurde analog Vergleichsbeispiel 7 hergestellt, jedoch wurden 4 mol% der Verbindung

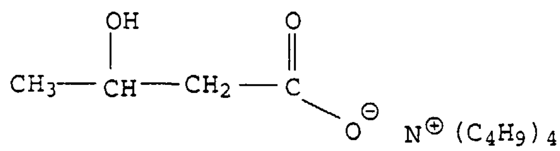

(= C7), bezogen auf Bis-4-Methylphenyl-sulfonyl-diazomethan, zugegeben.

Nach der Verarbeitung gemäß Vergleichsbeispiel 7 ergab sich ein Gamma-Wert von 7,5.

**Patentansprüche**

**1.** Positiv arbeitendes strahlungsempfindliches Gemisch im wesentlichen bestehend aus

($a_1$) mindestens einem säurelabile Gruppierungen enthaltenden, in Wasser unlöslichen organischen polymeren Bindemittel, das durch Einwirkung von Säure in wäßrig-alkalischen Lösungen löslich wird, oder

($a_{2.1}$) einem in Wasser unlöslichen, in wäßrig-alkalischen Lösungen löslichen polymeren Bindemittel und

($a_{2.2}$) einer niedermolekularen organischen Verbindung, deren Löslichkeit in einem wäßrig-alkalischen Entwickler durch Einwirkung von Säure erhöht wird, und

(b) mindestens einer organischen Verbindung, welche unter Einwirkung von aktinischer Strahlung eine Säure erzeugt,

sowie gegebenenfalls
(c) einer oder mehreren weiteren von (b) verschiedenen organischen Verbindungen,
dadurch gekennzeichnet, daß mindestens eine der Komponenten (b) und (c) eine Gruppierung der Formeln

(Ia) 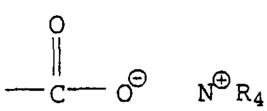 oder 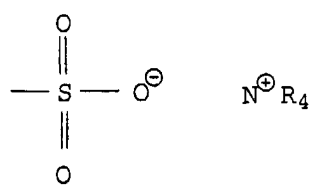 (Ib)

enthält, oder
Komponente (c) der Formel (II) entspricht

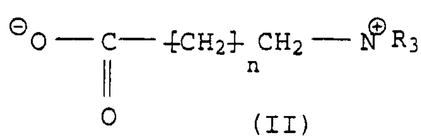

(II)

wobei R für einen Alkylrest mit 1 bis 6 Kohlenstoffatomen und n = 1 bis 6 stehen.

**2.** Strahlungsempfindliches Gemisch nach Anspruch 1, dadurch gekennzeichnet, daß es als Komponente (c) eine organische Verbindung aus der Gruppe

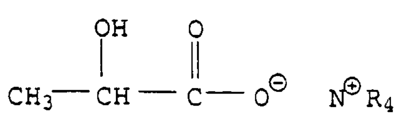

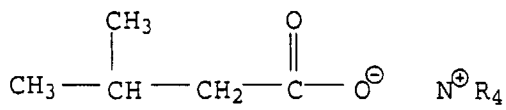

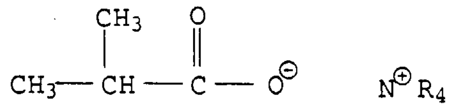

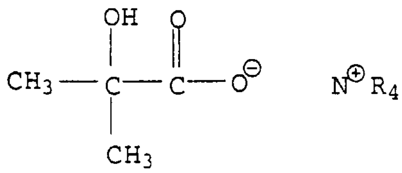

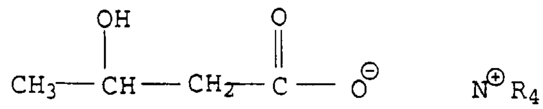

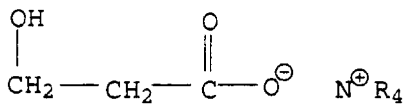

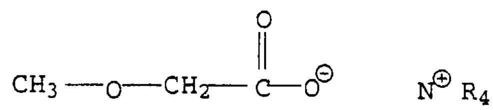

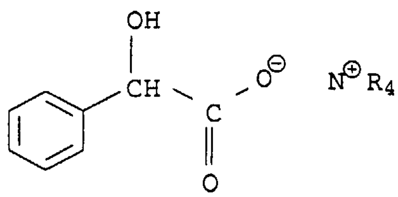

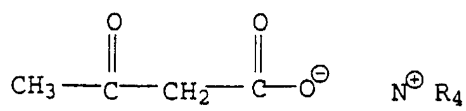

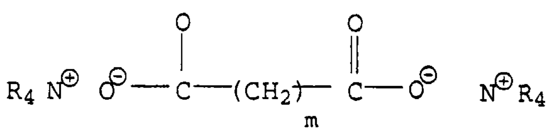

mit m = 1 bis 4

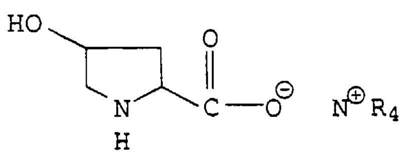 und 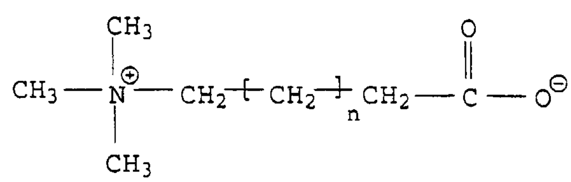

mit n = 1 bis 3
enthält.

3. Strahlungsempfindliches Gemisch nach einem der vorhergehenden Ansprüche, dadurch gekennzeichnet, daß es als Komponente (b) ein Sulfoniumsalz, Iodoniumsalz, Benzointosylat, Pyrogalloltrimesylat, o-Nitrobenzyltosylat, Diaryldisulfon, Bis-arylsulfonyl-diazomethan, Bis-cyclohexylsulfonyl-diazomethan und/oder Iminosulfonate mit der Struktureinheit

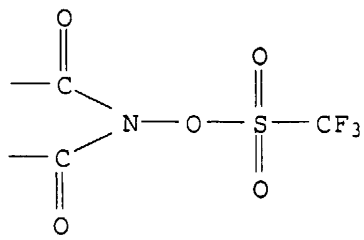

enthält.

**4.** Strahlungsempfindliches Gemisch nach einem der vorhergehenden Ansprüche, dadurch gekennzeichnet, daß die Komponente ($a_1$) Einheiten der Formeln (VI), (VII) und gegebenenfalls (VIII)

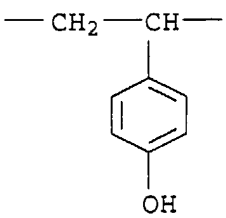
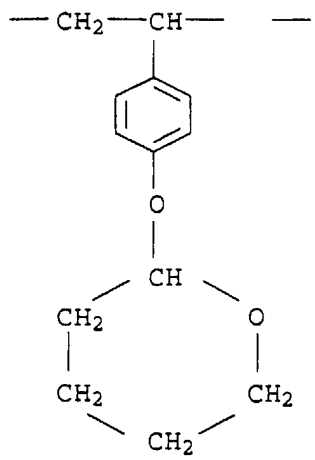
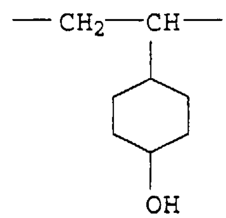

(VI) (VII) (VIII)

eingebaut enthält.

**5.** Strahlungsempfindliches Gemisch nach Anspruch 1, dadurch gekennzeichnet, daß in den Formeln (Ia), (Ib) oder (II) R für $CH_3$ steht.

**6.** Strahlungsempfindliches Gemisch nach einem der vorhergehenden Ansprüche, dadurch gekennzeichnet, daß es in Form einer Lösung in einem organischen Lösungsmittel oder Lösungsmittelgemisch vorliegt.

**7.** Verfahren zur Herstellung lichtempfindlicher Beschichtungsmaterialien, dadurch gekennzeichnet, daß ein strahlungsempfindliches Gemisch gemäß einem der Ansprüche 1 bis 6 eingesetzt wird.

**8.** Verfahren zur Herstellung von Reliefstrukturen durch Auftragen eines strahlungsempfindlichen Gemisches in einer Schichtdicke von 0,1 bis 5 µm auf ein in üblicher Weise vorbehandeltes Substrat, Trocknen bei Temperaturen von 70 bis 140°C, bildmäßiges Belichten mit aktinischem Licht, gegebenenfalls Erhitzen auf Temperaturen von 40 bis 160°C, und Entwickeln mit einer wäßrig-alkalischen Lösung, dadurch gekennzeichnet, daß ein strahlungsempfindliches Gemisch gemäß einem der Ansprüche 1 bis 6 eingesetzt wird.

## Claims

**1.** A positive-working radiation-sensitive mixture essentially consisting of

($a_1$) at least one water-insoluble, organic polymeric binder which contains acid-labile groups and becomes soluble in aqueous alkaline solutions as a result of the action of acid, or

($a_{2.1}$) a polymeric binder which is insoluble in water and soluble in aqueous alkaline solutions and

($a_{2.2}$) a low molecular weight organic compound whose solubility in an aqueous alkaline developer is increased as a result of the action of acid, and

(b) at least one organic compound which produces an acid under the action of actinic radiation,

and, if required,
(c) one or more further organic compounds which differ from (b),
wherein at least one of the components, (b) and (c) contains a group of the formula

(Ia) 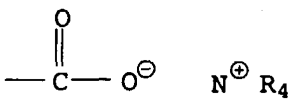 or 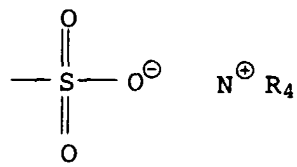 (Ib),

or
component (c) is of the formula (II)

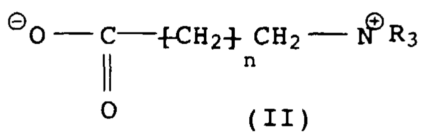

(II)

where R is alkyl of 1 to 6 carbon atoms and n is from 1 to 6.

**2.** A radiation-sensitive mixture as claimed in claim 1, which contains, as component (c), an organic compound selected from the group consisting of

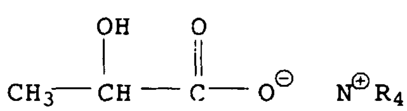

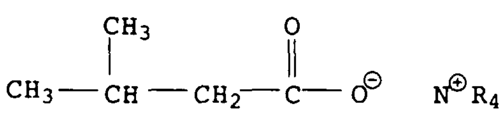 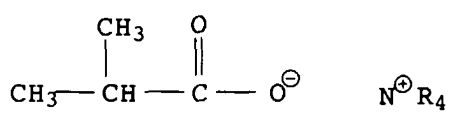

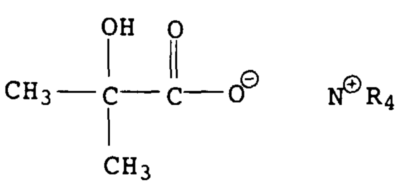 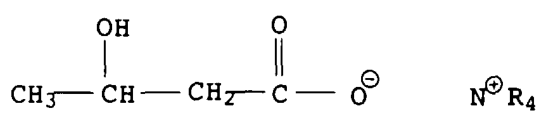

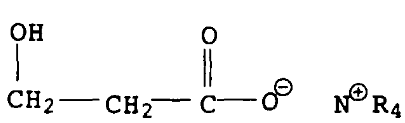 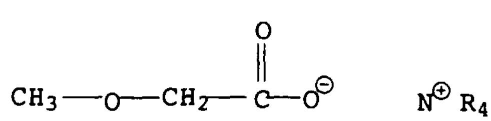

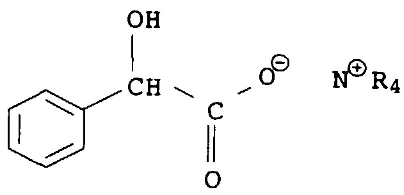

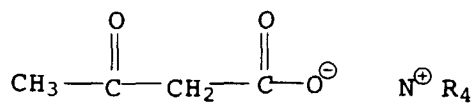

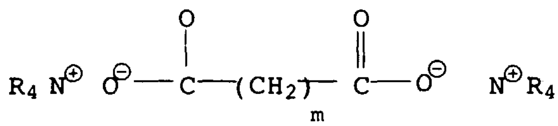

where m is 1 to 4

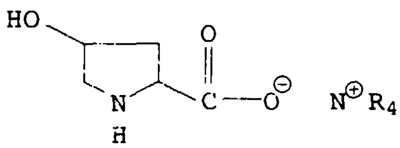

and

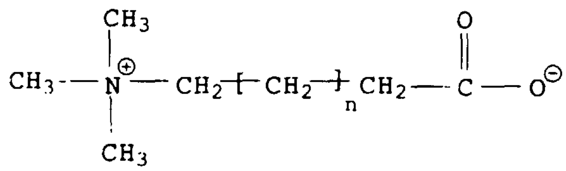

where n is 1 to 3.

**3.** A radiation-sensitive mixture as claimed in any of the preceding claims, which contains, as component (b), a sulfonium salt, iodonium salt, benzoin tosylate, pyrogallol trimesylate, o-nitrobenzyl tosylate, diaryl disulfone, bisarylsulfonyldiazomethane, biscyclohexylsulfonyldiazomethane or an iminosulfonate having the structural unit

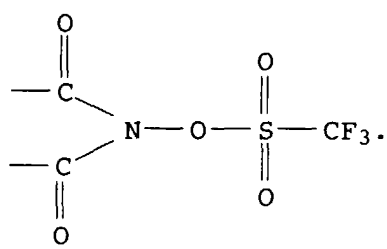

**4.** A radiation-sensitive mixture as claimed in any of the preceding claims, wherein the component ($a_1$) contains units of the formulae (VI), (VII) and, if required, (VIII)

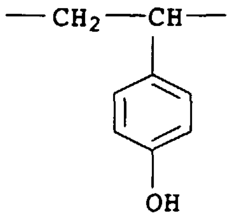

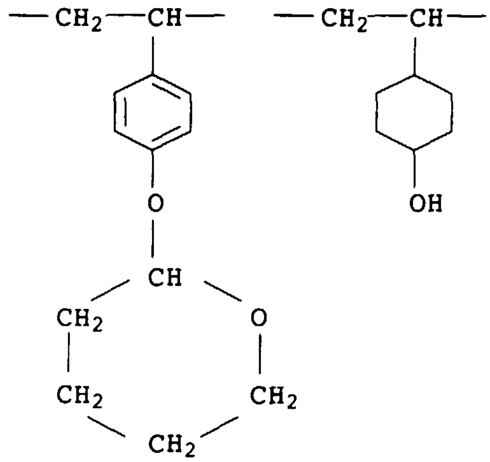

(VI) (VII) (VIII).

5. A radiation-sensitive mixture as claimed in claim 1, wherein, in the formulae (Ia), (Ib) or (II), R is $CH_3$.

6. A radiation-sensitive mixture as claimed in any of the preceding claims, which is in the form of a solution in an organic solvent or solvent mixture.

7. A process for the preparation of photosensitive coating materials, wherein a radiation-sensitive mixture as claimed in any of claims 1 to 6 is used.

8. A process for the production of relief structures by application of a radiation-sensitive mixture in a layer thickness of from 0.1 to 5 μm to a conventionally pretreated substrate, drying at from 70 to 140°C, imagewise exposure with actinic light, if required postbake at from 40 to 160°C, and development with an aqueous alkaline solution, wherein a radiation-sensitive mixture as claimed in any of claims 1 to 6 is used.

## Revendications

1. Mélange sensible aux rayonnements, opérant en positif, consistant essentiellement en

   (**a$_1$**) au moins un liant organique polymère insoluble dans l'eau, contenant des groupements instables aux acides, qui devient soluble dans les solutions aqueuses alcalines sous l'action d'un acide, ou bien
   (**a$_{2.1}$**) un liant polymère insoluble dans l'eau mais soluble dans les solutions aqueuses alcalines et
   (**a$_{2.2}$**) un composé organique à bas poids moléculaire dont la solubilité dans un révélateur aqueux alcalin est accrue sous l'action d'un acide et
   (**b**) au moins un composé organique qui produit un acide sous l'action de rayonnements actiniques,

   et le cas échéant
   (**c**) un ou plusieurs composés organiques autres que (b), caractérisé par le fait que l'un au moins des composants(b) et (c) contient un groupement de formule

(Ia) 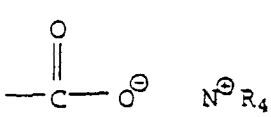 ou 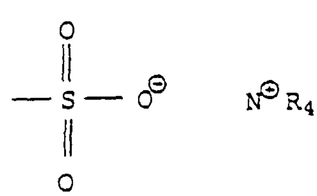 (Ib)

   ou bien
   le composant (c) répond à la formule II

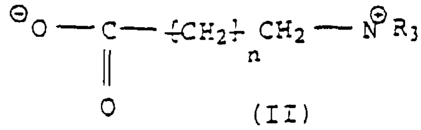

(II)

dans laquelle R représente un groupe alkyle en C1-C6 et n est un nombre allant de 1 à 6.

2. Mélange sensible aux rayonnements selon la revendication 1, caractérisé par le fait qu'il contient en tant que composant (c) un composé organique du groupe suivant :

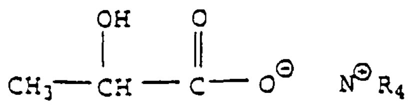

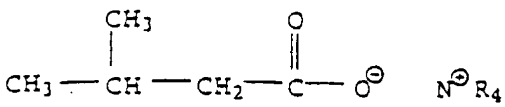

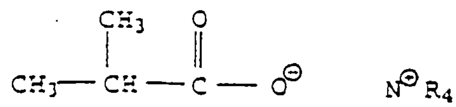

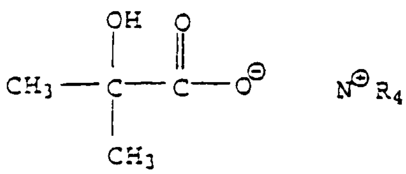

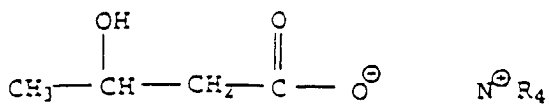

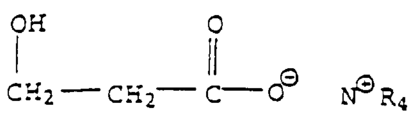

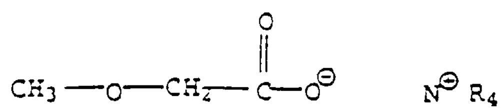

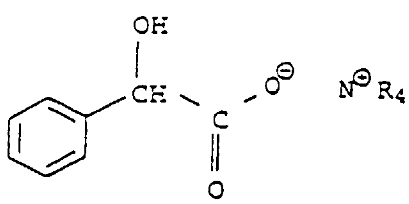

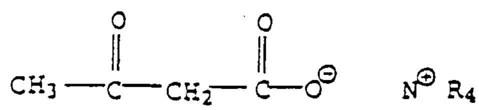

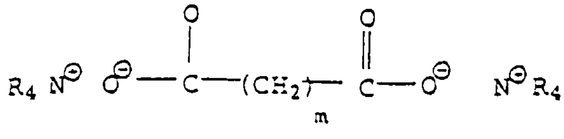

avec m = 1 à 4

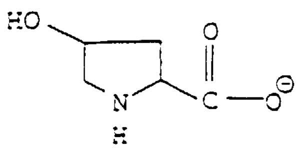

$N^{\oplus}R_4$ und

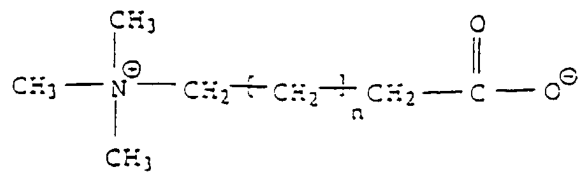

avec n = 1 à 3

**3.** Mélange sensible aux rayonnements selon l'une des revendications qui précèdent, caractérisé par le fait qu'il contient en tant que composant (b) un sel de sulfonium, un sel d'iodonium, le toluènesulfonate de la benzoïne, le triméthanesulfonate du pyrogallol, le toluènesulfonate d'o-nitrobenzyle, une diaryldisulfone, un bis-arylsulfonyl-diazométhane, le bis-cyclohexylsulfonyl-diazométhane et/ou un iminosulfonate contenant le motif de structure

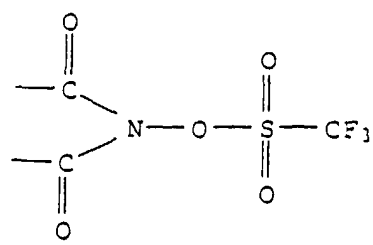

**4.** Mélange sensible aux rayonnements selon l'une des revendications qui précèdent, caractérisé par le fait que le composant (a1) contient dans sa structure des motifs de formules VI, VII et le cas échéant VIII

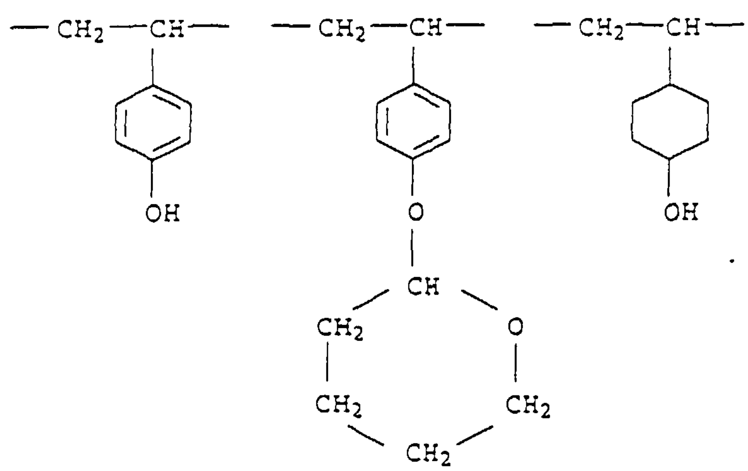

(VI) (VII) (VIII)

**5.** Mélange sensible aux rayonnements selon la revendication 1, caractérisé par le fait que, dans les formules Ia, Ib ou II, R représente CH3.

**6.** Mélange sensible aux rayonnements selon une des revendications qui précèdent, caractérisé par le fait qu'il est à l'état de solution dans un solvant ou mélange solvant organique.

**7.** Procédé pour préparer des matières de revêtement sensibles à la lumière, caractérisé par le fait que l'on utilise un mélange sensible aux rayonnements selon l'une des revendications 1 à 6.

**8.** Procédé pour former des structures en relief par application d'un mélange sensible aux rayonnements à une épaisseur de couche de 0,1 à 5 µm sur un support traité au préalable de la manière habituelle, séchage à des températures de 70 à 140° C, exposition à la lumière actinique avec formation d'une image, le cas échéant chauffage à des températures de 40 à 160° C, et développement à l'aide d'une solution aqueuse alcaline, caractérisé par le fait que l'on utilise un mélange sensible aux rayonnements selon l'une des revendications 1 à 6.